# EUROPEAN PATENT SPECIFICATION

(11) **EP 2 240 615 B1**
(45) Date of publication and mention of the grant of the patent: **17.07.2013**
(21) Application number: 08862671.8
(22) Date of filing: 19.12.2008
(51) Int. Cl.: C22C 12/00, C22C 1/00, H01L 35/18

(54) **METHOD FOR PRODUCING A THERMOELECTRIC INTERMETALLIC COMPOUND**
VERFAHREN ZUR HERSTELLUNG EINER THERMOELEKTRISCHEN INTERMETALLISCHEN VERBINDUNG
PROCÉDÉ DE PRODUCTION D'UN COMPOSÉ INTERMÉTALLIQUE THERMOÉLECTRIQUE

(30) Priority: 19.12.2007 GB 0724752
(43) Date of publication of application: 20.10.2010
(73) Proprietor: Biometric Technology Solutions Limited, Dublin 18 (IE)
(72) Inventor: BARI, Mazhar, Ali, Dublin 18 (IE)
(74) Representative: Setna, Rohan P.
(86) International application number: PCT/GB2008/004209
(87) International publication number: WO 2009/077767

(56) References cited:
- US-A1- 2002 176 815
- US-B1- 6 207 886
- BERARDAN D ET AL: "Preparation and chemical properties of the skutterudites (Ce-Yb)yFe4-x(Co/Ni)xSb12" MATERIALS RESEARCH BULLETIN, ELSEVIER, KIDLINGTON, GB, vol. 40, no. 3, 8 March 2005 (2005-03-08), pages 537-551, XP002519021 ISSN: 0025-5408
- BERARDAN D ET AL: "Existence, structure and valence properties of the skutterudites CeyFe4-xCoxSb12" JOURNAL OF ALLOYS AND COMPOUNDS, ELSEVIER SEQUOIA, LAUSANNE, CH, vol. 350, no. 1-2, 17 February 2003 (2003-02-17), pages 30-35, XP002519022 ISSN: 0925-8388

## Description

The present invention relates to the field of thermoelectrics, specifically an intermetallic compound and a method of manufacture thereof. These materials can utilize a thermal gradient to generate electrical power or can be electrically powered for heating/cooling applications.

### Background to the Invention

Increasing consciousness of environmental issues has lead to a desire for increased energy efficiency in a range of energy production methods. Considerable interest has been invested in the production, development and use of thermoelectric materials. Thermoelectric materials convert heat flow into electrical current and vice versa. Therefore these materials have been sought for the production of electricity from the surroundings, for example, in power station cooling towers to extract energy from the hot exhaust gases. Other practical uses which have been envisioned include nuclear-heated power generating applications for powering spacecraft where solar power is not feasible. The thermoelectric power and, hence, the figure of merit of conventional bulk thermoelectric materials are not currently sufficient for power or space applications.

In the automobile industry thermoelectric materials could be used to transform heat directly into electrical energy, allowing fuel to be used for power generation more efficiently. Power generators in cars could be made obsolete by utilizing heat from exhaust gases. Thermo-electric waste heat recovery is also applicable to modes of transportation such as diesel-electric locomotives, locomotive diesel engines, automotive diesel engines, diesel-electric hybrid buses, fuel cells, etc.

The cooling capability of thermoelectric devices has also been viewed as a solution to other environmental problems. Specifically the use of a thermoelectric material to extract heat from a container, for example a refrigerator, removes the requirement for potentially damaging refrigerants. Furthermore, such devices enable new designs of coolers/heaters and air conditioning.

Thermoelectric materials are particularly favoured for the above applications due to the simplicity of their design. The solid state components are robust and highly reliable with low failure rates. In the use of a thermoelectric material, either in the generation of electrical power, or the creation of a temperature gradient, there are no pollutants released into the atmosphere.

Furthermore, thermoelectric materials are scalable and hence ideal for miniature power generation, for example, in thermoelectric micro devices. A thermoelectric cooler will enable temperature control for bio-medical lab-on-chip applications and optoelectronics hundreds of times faster and more precisely than existing technology. Micro thermoelectronic generators will enable self powering microelectonics such as a thermoelectronic wristwatch or, combined with a microcombustor could replace Li-ion batteries in portable electronics. It is hoped that the use of such materials could allow improvements in the reliability of batteries.

The present invention aims to overcome or at least mitigate at least some of the problems associated with the prior art.

The suitability of a material for thermoelectric applications is determined by its dimensionless figure of merit, ZT. ZT = (S²σT)/(k) where S, σ, k and T are the thermo-power (Seebeck coefficient), electrical conductivity, thermal conductivity and temperature respectively. Thermal conductivity 'k' is sum of two contributions - electronic (kₑ) and lattice (k₁) contributions. A good thermoelectric material has a large ZT value. This large value may result from a large Seebeck coefficient, a high electrical and/or low thermal conductivity. The electronic properties are determined by the power factor, S²σT, which can be optimized by tuning the carrier concentration.

ZT may be specified at the temperature at which it is measured. For example, ZT_{600K} is the thermoelectric dimensionless figure of merit of a material at 600 degrees Kelvin.

Binary skutterudites are semiconductors with small band gaps of 100 meV, high carrier mobility, and modest Seebeck coefficients. Binary skutterudite compounds crystallize in a body-centred-cubic structure with space group Im3 and have the form MX₃, where M is commonly Fe, Co, Rh or Ir and X is P, As or Sb. Despite having excellent electronic properties, binary skutterudites have thermal conductivities too high to compete with state-of-the-art thermoelectric materials.

However, filled skutterudites have much lower thermal conductivities. Therefore, filled skutterudites are increasingly popular as a thermoelectric material due to their lower thermal conductivities, as shown in US 6 207 886.

Filled skutterudites can be formed by inserting rare earth guest atoms interstitially into large voids in the crystal structure of binary skutterudites. The chemical composition for filled skutterudites can be expressed as Z_{y}M₄X₁₂, where Z represents a guest atom, typically a rare earth atom, and y is its filling fraction. Compared to binary skutterudites, the lattice thermal conductivities of the rare earth filled skutterudites are significantly reduced over a wide temperature range. As the thermal conductivity due to lattice (k₁) are minimized, ZT is maximized. This property of filled skutterudites is due to the scattering of heat-carrying low-frequency phonons by the heavy rare earth atoms, which rattle inside the interstitial voids in the skutterudite crystal structure. The filled skutterudites possess attractive electrical transport properties and serve as potential candidates for achieving figure of merit significantly larger than conventional thermoelectric materials.

The thermoelectric power of these materials can be understood in terms of the phonon glass-electron model. The filler atoms can 'rattle' inside the oversized voids in the skutterudite structure. The generation of low frequency phonon modes increases the phonon-phonon scattering which in turn decreases the magnitude of k₁.

The value ZT = 1 can be viewed as a bench mark of quality of a thermoelectric material. In recent years, both n- and p-type rare earth filled skutterudites have been reported to have ZT values around 1 above 500 °C. One aim of the present invention is to provide a thermoelectric material having a value greater than 1.4 or 1.5 at 600K and to search for novel materials for both cooling and power applications.

For power and generator applications there is a need for materials and manufacturing techniques which yield high figure of merit, with a large electrical conductivity and low thermal conductivity. It is also desirable that the magnitude of the thermo-power increases with increasing temperature.

### Summary of the Invention

In the first aspect, the present invention provides a method for producing an intermetallic compound as given in claim 1.

The method of the present invention provides an intermetallic compound exhibiting a ZT₆₀₀ₖ value of ≥ 0.9 and having the formula:

A'_{a'} B'_{b'} X'_{c'}

wherein,
A' is selected from at least two of La, Ce, Pr, Nd, Pm, Sm, Eu, Yb, Ca, Sr, Ba and Tl, and mixtures of three or more thereof;
B' is selected from one or more transition metal atoms;
X' is selected from one or more Group IIIA-VIIA atoms;
a' is the sum of all A atoms wherein 0 < a' ≤ 1
X a_{'} is the sum of all B atoms wherein 3.8 ≤ b' ≤ 4; and
c' is the sum of all X atoms wherein 11 ≤ c' ≤ 12.

### Description of the Figures

Figure 1 shows the variation of thermoelectric power for (a) Ce_{0.95}Fe₄Sb₁₂ (b) Ce_{0.85}Fe_{2.8}Co₁₋₂Sb₁₂ (c) Ce_{0.4}Yb_{0.53}Fe_{2.8}Co₁₋₂Sb₁₂ and (d) annealed Ce_{0.4}Yb_{0.53}Fe_{2.8}Co_{1.2}Sb₁₂ in the temperature range 10-600 K.
Figure 2 shows the variation of thermoelectric power for (a) La_{0.85}Fe₄Sb₁₂ (b) La_{0.85}Fe_{2.8}Co_{1.2}Sb₁₂ (c) La_{0.4}Yb_{0.53}Fe_{2.8}Co_{1.2}Sb₁₂ and (d) annealed Ce_{0.4}Yb_{0.53}Fe_{2.8}Co_{1.2}Sb₁₂ in the temperature range 10-600 K.
Figure 3 shows the resistivity against temperature plots of (a) Ce_{0.4}Yb_{0.53}Fe₄Sb₁₂ (b) annealed Ce_{0.4}Yb_{0.53}Fe₄Sb₁₂ (c) Ce_{0.4}Yb_{0.53}Fe_{2.8}Co_{1.2}Sb₁₂ (d) annealed Ce_{0.4}Yb_{0.53}Fe_{2.8}Co_{1.2}Sb₁₂ and (e) annealed La_{0.4}Yb_{0.53}Fe_{2.8}Co_{1.-2}Sb₁₂ in the temperature range 10-600 K.
Figure 4 shows the figure of merit for several filled skutterudite compositions before and after annealing in Sb vapour.

### Detailed Description of the Invention

The present invention will now be further described. In the following passages different aspects of the invention are defined in more detail. Each aspect so defined may be combined with any other aspect or aspects unless clearly indicated to the contrary. In particular, any feature indicated as being preferred or advantageous may be combined with any other feature or features indicated as being preferred or advantageous.

Advantageously, the present inventors have found that by using the method of the present invention, intermetallic compounds may be provided which have improved thermoelectric properties.

Preferably the method of the present invention produces an intermetallic compound exhibiting a ZT₆₀₀ₖ value of ≥ 0.9, more preferably ≥1, ≥1.1, or ≥1.2.

The method of the present invention comprises at least three steps. It will, however, be understood that further steps may be incorporated before, between and/or after these three steps.

The first step involves providing components A, B and X, wherein A, B and X are:
A is selected from at least two of La, Ce, Pr, Nd, Pm, Sm, Eu, Yb, In, Ca, Sr, Ba and Tl, and mixtures of two or more thereof;
B is selected from one or more transition metal atoms; and
X is selected from one or more Group IIIA-VIIA atoms.
Solid state reaction of components A, B and X provides an intermetallic compound having a filled skutterudite structure and formula of

AₐB_{b}X_{c}

wherein A, B and X are as defined above and
a is the sum of all A atoms wherein 0 < a ≤ 1
b is the sum of all B atoms wherein 3.8 ≤ b ≤ 4; and
c is the sum of all X atoms wherein 8 ≤ c ≤ 12.

Preferably, stoichiometric mixtures of the reactants A, B and X are reacted together to form the intermetallic compound of formula AₐB_{b}X_{c}.

Typically the components A, B and X will be provided as ingots of the elements. Such ingots are readily available commercially. Conventional solid state reaction techniques are well known. The filled skutterudite structure of formula of AₐB_{b}X_{c} may be produced, for example, by baking ingots of the elements together in an evacuated container at a suitable time for a suitable duration. The baking is preferably carried out under vacuum or under an inert atmosphere according to conventional methods such as sealing in evacuated glass tubes. The inert atmosphere prevents contamination, oxidation or decomposition of the produced intermetallic. Alternatively, or additionally, unreactive metal tubes may be used.

Preferably the solid state reaction of A, B and X to form the intermetallic compound having a filled skutterudite structure and a formula of AₐB_{b}X_{c} is carried out by heating at a temperature range of from 500°C to 900°C for from 1 to 7 days.

In the method of the present invention A is selected from rare earth elements and mixtures of two or more thereof. Preferably, A is selected from one or more of La, Ce and Yb. Most preferably A is Ce and Yb, or La and Yb.

Preferably in the method of the present invention B is selected from one or more of Fe, Co, Rh, Ru, Os and Ir. More preferably B is Fe and Co. B may be Fe.

Preferably X is selected from C, Si, Ge, Sn, Pb, N, P, As, Sb, Bi, S, Se and Te. More preferably still X is P, As or Sb. Most preferably X is Sb.

"a" is the sum of all A atoms in the intermetallic compound AₐB_{b}X_{c}. Advantageously "a" is in the range of from 0.5 to 1, more preferably "a" is in the range of from 0.8 to 1, most preferably "a" is 1. "a" may be in the range 0.81-0.87.

"b" is the sum of all B atoms in the intermetallic compound AₐB_{b}X_{c}. "b" is in the range of from 3.8 to 4, most preferably "b" is 4.

"c" is the sum of all X atoms in the intermetallic compound AₐB_{b}X_{c}. Preferably "c" is in the range of from 11 to 12.

The second step comprises melting the intermetallic compound having a filled skutterudite structure produced in step (1) in the presence of additional X. Melting may be carried using an arc and/or an induction melter. The melting step may be vacuum melting in, for example, a quartz tube.

The term "additional X" is used herein to mean that the filled skutterudite is melted in the presence of at least some X which has not originated from the filled skutterudite structure. The additional X may optionally be added to the filled skutterudite in the reaction chamber before melting.

The third step comprises annealing the filled skutterudite in an X-rich environment at a temperature equal to, or greater than the phase formation temperature of the filled skutterudite. In particular, in the method of the present invention the intermetallic compound is annealed in the presence of additional X.

The term "additional X" is used herein to mean that the filled skutterudite is annealed in the presence of at least some X which has not originated from the filled skutterudite structure. The additional X may optionally be added to the filled skutterudite in the reaction chamber before annealing.

Preferably the additional X is the same as the X present in the filled skutterudite structre of formula AₐB_{b}X_{c}. Preferably X is P, As or Sb. Most preferably X is Sb.

By annealing, it is to be understood that the intermetallic is heated to relieve stresses in the structure. Annealing involves heating to a temperature where diffusion can occur. Maintaining a metal at elevated temperatures reduces dislocation, vacancies, frozen-in stress and other metastable conditions. There are several stages in the annealing process, with the first being the recovery phase, which results in softening of the metal through removal of crystal defects and the internal stresses which they cause. The second phase is recrystallization, where new grains nucleate and grow to replace those deformed by internal stresses. Finally a very slow cooling phase is used to induce softness, relieve internal stresses, refine the structure and improve cold working properties. The slow cooling minimises thermal gradients which could re-introduce stress by differential thermal contraction.

The process of annealing can allow guest atoms to be incorporated into substitutional positions in the crystal lattice, resulting in drastic changes in the electrical properties of the material. Annealing occurs by the diffusion of atoms within a solid material, so that the material progresses towards its equilibrium state. Heat is needed to increase the rate of diffusion by providing the energy needed to break and form new bonds. The movement of atoms has the effect of redistributing and destroying the dislocations in metals.

The amount of process-initiating Gibbs free energy in a deformed metal is also reduced by the annealing process. In practice and industry, this reduction of Gibbs free energy is termed "stress relief."

Thus, the relief of internal stresses is a thermodynamically spontaneous process, however, at room temperatures, it is a very slow process. Therefore, the high temperatures at which the annealing process occurs serve to accelerate this slow-albeit-spontaneous process.

The step of annealing in an atomsphere rich in X (preferably an atmosphere comprising Sb and optionally Yb) allows the compound to settle in a high temperature phase structure with very few lattic vacancies, these being filled by the excess vapours provided. Whilst not wishing to be bound by particular theory, it appears that this vacancy filing serves to improve the thermoelectric properties of the material. This is surprising as a number of electronic properties of n- and p-type doped semiconductors arise from having vacancies in the lattice structure.

The annealing step (3) may also be carried out in the presence of additional A, wherein A is as defined above.

The method of the present invention may further comprise a step of pelletising the intermetallic compound provided in step (1) before the melting step (2).

Advantageously the annealing step is performed for a duration greater than 6 hours, 12 hours, 24 hours, more preferably for longer than 72 hours and most preferably for a duration greater than 1 week. Annealing is preferably performed at no less than 50 °C less than the phase formation temperature of the target compound. The phase formation temperature of YbFe₄Sb₁₂, for example, is about 650 °C.

The present invention provides a method for producing an intermetallic compound, the method comprising:
(1) providing components A, B and X, wherein A, B and X are:
   A is selected from at least two of La, Ce, Pr, Nd, Pm, Sm, Eu, Yb, Ca, Sr, Ba and Tl, and mixtures of three or more thereof;
   B is selected from one or more transition metal atoms;
   X is selected from one or more Group IIIA-VIIA atoms and forming by solid state reaction of components A, B and X an intermetallic compound having a filled skutterudite structure and formula of

      AₐB_{b}X_{c}

      wherein A, B and X are as defined above and
      a is the sum of all A atoms wherein 0 < a ≤ 1
      b is the sum of all B atoms wherein 3.8 ≤ b ≤ 4; and
      c is the sum of all X atoms wherein 8 ≤ c ≤ 12;
(2) melting the intermetallic compound having a filled skutterudite structure produced in step (1) in the presence of additional X; and
(3) annealing the intermetallic compound of step (2) in the presence of additional X at a temperature equal to, or greater than the phase formation temperature of the intermetallic compound.

The present inventors have thereby prepared intermetallic compounds exhibiting a ZT₆₀₀ₖ value of ≥ 0.9 and having the having the formula:

A'_{a'}, B'_{b'} X'_{c'}

wherein,
A' is selected from at least two of La, Ce, Pr, Nd, Pm, Sm, Eu, Yb, Ca, Sr, Ba and Tl, and mixtures of three or more thereof;
B' is selected from one or more transition metal atoms;
X' is selected from one or more Group IIIA-VIIA atoms;
a' is the sum of all A' atoms wherein 0 < a' ≤ 1
b' is the sum of all B' atoms wherein 3.8 ≤ b' ≤ 4; and
c' is the sum of all X' atoms wherein 11 ≤ c' ≤ 12.

Preferably the intermetallic compound has the formula A'B'₄X'₁₂, where A', B' and X' are as defined above. It will, however, be understood that the compound may not be of this exact stoichiometric formula, there may be some deficiencies in the number of A', B' and/or X' atoms in the structure of the compound.

The intermetallic compound has a filled skutterudite structure (for example, LaFe₄P₁₂). Antonomides are an example of the filled skutterudite structure. They have a body centred cubic structure with square planar rings of Sb atoms. Metal atoms, for example, iron, form a simple cubic sub-lattice and the guest atoms occupy the two remaining holes in the unit cell.

A' is selected from at least two rare earth elements and mixtures of three or more of La, Ce and Yb. Preferably A' is Ce and Yb, or La and Yb.

Preferably B' is preferably one or more of Fe, Co, Rh, Ru, Os and Ir. More preferably, A' is Fe and Co. More preferably still, A' is Fe.

Preferably X' is selected from C, Si, Ge, Sn, Pb, N, P, As, Sb, Bi, S, Se, and Te. More preferably X is P, As or Sb. Most preferably X' is Sb.

"a' " is the sum of all A' atoms in the intermetallic compound. Advantageously "a' " is in the range of from 0.5 to 1, more preferably "a' " is in the range of from 0.8 to 1, most preferably "a' " is 1. "a' " may be in the range 0.81-0.87.

"b' " is the sum of all B atoms in the intermetallic compound. "b' " is in the range of from 3.8 to 4, preferably "b' " is 4.

"c' " is the sum of all X' atoms in the intermetallic compound. "c' " is in the range of from 11 to 12.

The intermetallic compound as described herein shows improved thermoelectric properties over prior art compounds. In particular, the intermetallic compounds have high dimensionless figure of merit (ZT) values. Preferably the intermetallic compound as described herein exhibits a ZT₆₀₀ₖ value of ≥ 1, more preferably ZT₆₀₀ₖ value of ≥ 1.1, more preferably still ZT₆₀₀ₖ value of ≥ 1.2.

In a preferred embodiment of the present invention, A' is Ce and Yb, B' is Fe and X' is Sb. For example, the intermetallic compound may have the formula Ce_{0.4}Yb_{0.25}Fe₄Sb₁₂.

In another embodiment of the present invention A' is La and Yb, B' is Fe and X' is Sb. For example, the intermetallic compound may have the formula La_{0.4}Yb_{0.25}Fe₄Sb₁₂.

In another embodiment of the present invention A' is La and Yb, B' is Fe and Co and X' is Sb. For example, the intermetallic compound may have the formula La_{0.4}Yb_{0.53}Fe_{2.8}Co_{1.2}Sb₁₂.

In an alternative embodiment, A' is Ce and Yb, or A' is Ce and La, B' is Fe and Co and X' is Sb. In particular, intermetallic compounds having the formulas Ce_{0.4}Yb_{0.53}Fe_{2.8}Co_{1.2}Sb₁₂ and Ce_{0.4}Yb_{0.53}Fe_{2.8}Co_{1.2}Sb₁₂ have been shown to have particularly high dimensionless figure of merit values, which may be up to or greater than 1.2.

The present inventors have found that substitution of Co at Fe sites in the filled skutterudite structure has been found to advantageously increase the figure of merit value. Cobalt also has the advantage that it is a cheap material for doping the filled skutterudite. In a preferred embodiment of the present invention B' is Fe and Co.

A film comprising the intermetallic compound as described herein may be provided be the method. The film may be a thin film, having a diameter of from 10nm to 10 micron, or from 10nm to 1 micron. The film may be made using standard techniques known in the art, for example sputtering techniques or pulse laser deposition. In one embodiment of the present invention the intermetallic compound as described herein may be deposited onto a substrate. The substrate may be, for example a metal, alloy, and/or a ceramic.

A wafer comprising the intermetallic compound as described herein may be provided by the method.

A peltier cooler comprising an intermetallic compound as described herein may be provided by the method.

In another aspect there is provided a thermoelectric generator comprising an intermetallic compound as described herein.

In a further aspect there is provided the use of an intermetallic compound as described herein as a thermoelectric material.

A peltier cooler/heater device comprising an intermetallic filled skutterudite compound as described above will have a high efficiency in converting inputted electricity to creating a large temperature gradient within the device. A thermoelectric generator comprising a filled skutterudite compound according to the present invention will have a high efficiency in producing electricity from a provided temperature gradient.

In another aspect there is provided a magnetoresistor comprising an intermetallic compound as described herein.

When the thermoelectric materials of the present invention are employed in magnetoresistors they are found to exhibit improved temperature stability of the magnetoresistance over an extended temperature range.

In a further aspect there is provided a multilayer comprising a first electrode, a second electrode, and an interlayer there between, said interlayer comprising an intermetallic compound as described herein.

The present invention will now be described further with reference to the following non-limiting examples.

### Examples

The compounds Z₁₋ₓYbₓFe₄Sb₁₂ and Z₁₋ₓYbₓFe_{3.9}Co_{0.01}Sb₁₂ (Z = Ce, La) were synthesized from high purity starting ingots of La, Ce, Yb, Fe, Co and Sb purchased from Sigma Aldrich. Stoichiometric mixtures of these reactants were then sealed in evacuated (< 10⁻⁶ mbar) quartz tubes. The samples were then heated very slowly with a ramp of 0.5°/min to 400 °C. The samples were kept at this temperature for 48 hours. The temperature was then raised to 700 °C for one week. Finally the samples were quenched to room temperature.

Each resulting sample was then pressed into pellets and induction melted. An excess of Yb and Sb were added prior to melting. The resulting dense pellets were then annealed at 700 °C for 24 hours.

Phase formation was confirmed by powder X-ray diffraction method and microscopy/composition analysis is carried out using SEM/EDX technique. Measurements of electrical resistance as a function of temperature were performed using a DC four-probe technique using spring contacts. Thermopower(S)measurements were performed in the temperature range by the differential method. Low temperature measurements were made with the help of close circuit refrigerator. High temperature measurements were carried out using a furnace and Pt thermocouples soldered to Platinum foils and temperature controlled by Eurotherm temperature controller. The Figure of Merit,ZT, is then computed by ZT = (S²σT)/(k). The thermal conductivity (k) was measured in a custom designed system using a steady state technique.

For thermoelectric power measurements, the samples were cut into bar-shaped samples by a diamond wheel. These bar-shaped sample were clamped between a heater and a copper block which acted as a heat sink and incorporated the thermometers and connections. The heater was pressed against the sample by springs. Discs of gold (foils) were fixed with electrically insulating and thermally conducting epoxy on top of the heater and on the bottom of the copper block to ensure a homogeneous lateral temperature and an electrical insulation of the sample. Two Chromel/Constantan thermocouples measured the steady thermal gradient (ΔT, typically 1 K) established across the sample and the voltage (thermoelectric voltage) was measured. Resistivity measurements were carried by standard van der Pauw four probe method.

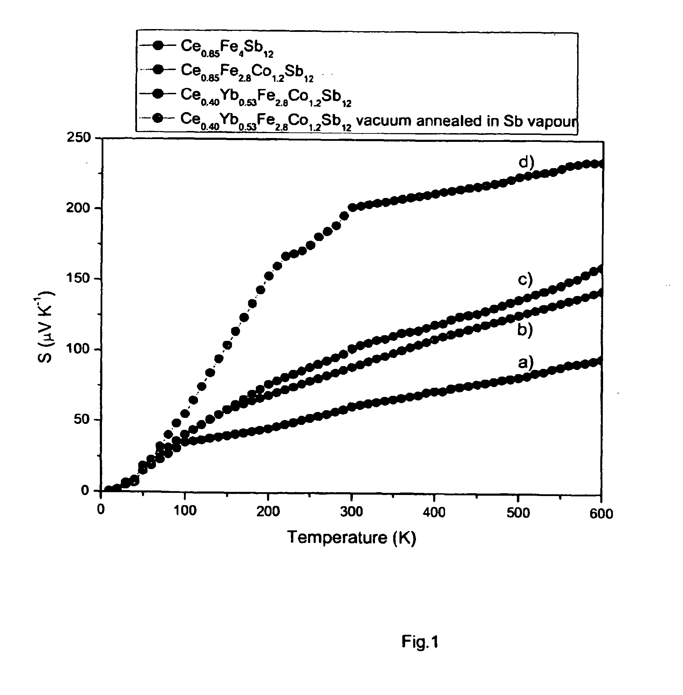

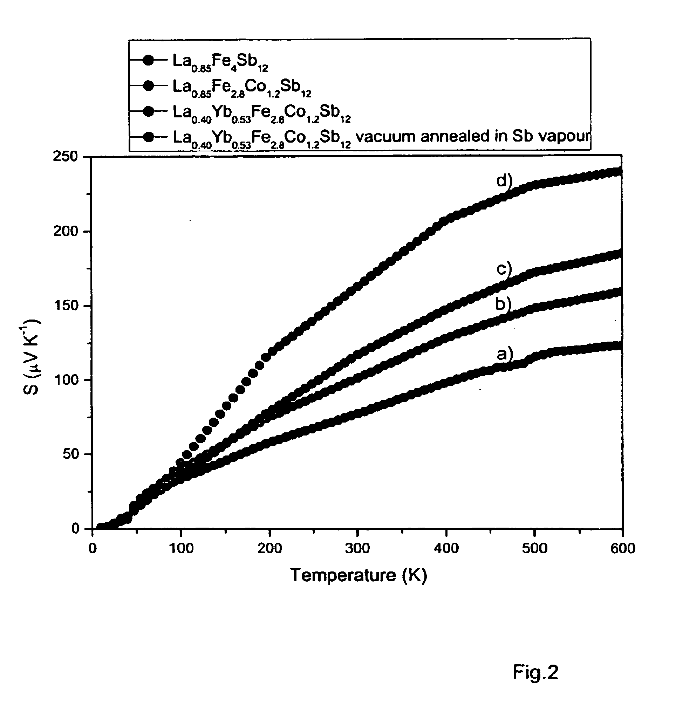

Figures 1&2 illustrate the Seebeck coefficient of compounds (Ce, Yb) Fe₄Sb₁₂ and (La,Yb) Fe₄Sb₁₂ in the temperature range 10-600 K. It can be noted that Seebeck coefficient increases with temperature up to 600 K for all compositions.

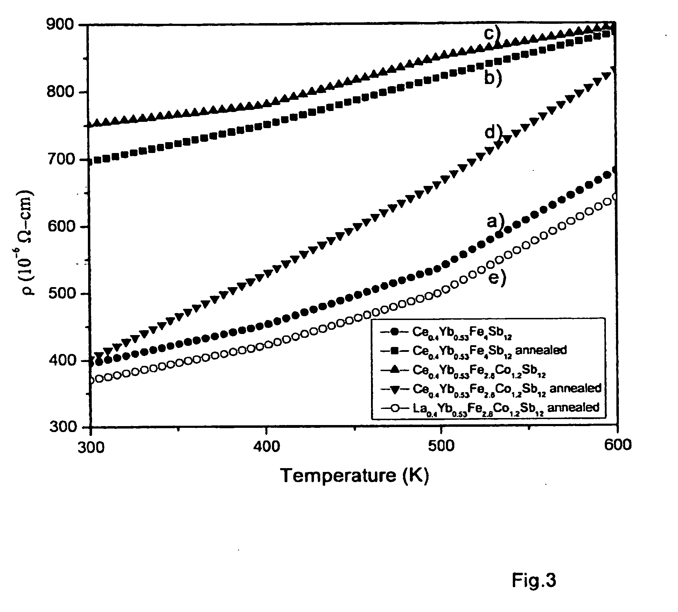

Resistivity plots of (Ce,Yb)Fe₄Sb₁₂ and (La, Yb) Fe₄Sb₁₂ are shown in Figure 3. The resistivity of all of the compounds indicated metallic behaviour. Room temperature resistivity decreased with Yb doping in both series, as shown in Table I and Figure 3. The linear variation of resistivity as a function of temperature can be explained by the semi-metallic behaviour found in Fe-rich filled skutterudites.

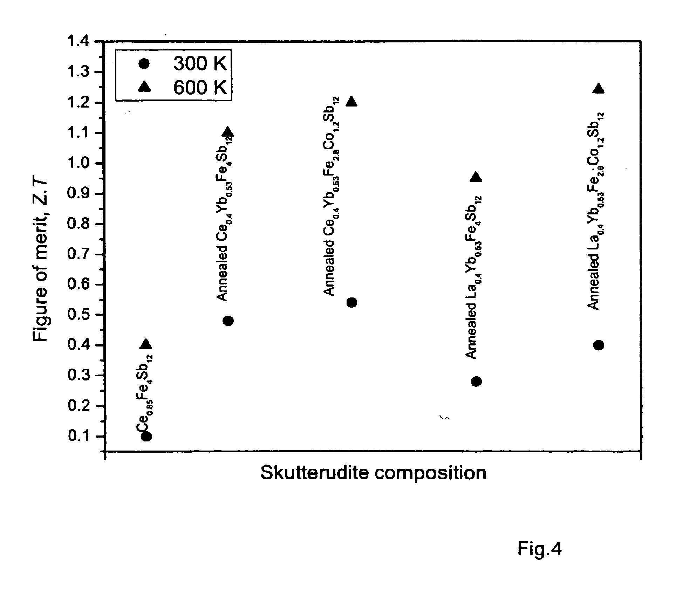

Figure 4 shows the calculated dimensionless figure of merit for Ce_{0.4}Yb_{0.53}Fe₄Sb₁₂ and Ce_{0.4}Yb_{0.53}Fe_{2.8}Co_{1.2}Sb₁₂ before and after annealing. The composition Ce_{0.4}Yb_{0.53}Fe₄Sb₁₂ has ZT = 0.27 at room temperature which increases with increasing temperature to ZT = 0.61. Annealing in Sb atmosphere has profound effect on thermo-power and hence the figure of merit. The figure of merit of annealed Ce_{0.4}Yb_{0.53}Fe₄Sb₁₂ reaches 0.48 and 1.1 at 300 K and 600 K respectively.

Table I summarizes the values of resistivity values (ρ)(values in brackets correspond to 600 K), Seebeck coefficient (S), thermal conductivity (λ) and figure of merit ZT at 300 K and 600 K for (Ce, Yb) Fe₄Sb₁₂ and (La, Yb) Fe₄Sb₁₂ and related compounds.

**Table I**

| Compound | S (µV K⁻¹) | ρ (10⁻⁶ Ω cm) | λ (W m⁻¹ K⁻¹) | ZT_{300K} | ZT_{600K} |
|---|---|---|---|---|---|
| Ce_{0.85}Fe₄Sb₁₂ | 61 (95) | 405 (470) | 2.9 | 0.10 | 0.40 |
| Ce_{0.4}Yb_{0.53}Fe₄Sb₁₂ | 100 (140) | 395 (680) | 2.8 | 0.27 | 0.61 |
| Annealed Ce_{0.4}Yb_{0.53}Fe₄Sb₁₂ | 125 (175) | 370 (640) | 2.6 | 0.48 | 1.1 |
| Ce_{0.85}Fe_{2.8}Co_{1.2}Sb₁₂ | 90 (144) | 446 (875) | 2.6 | 0.21 | 0.54 |
| Ce_{0.4}Yb_{0.53}Fe_{2.8}Co_{1.2}Sb₁₂ | 102 (160) | 402 (830) | 2.6 | 0.30 | 0.71 |
| Annealed Ce_{0.9}Yb_{0.53}Fe_{2.8}Co_{1.2}Sb₁₂ | 202 (234) | 752 (895) | 3.0 | 0.54 | 1.2 |
| La_{0.85}Fe₄Sb₁₂ | 77 (123) | 443 (610) | 3.5 | 0.11 | 0.43 |
| La_{0.4}Yb_{0.53}Fe₄Sb₁₂ | 95 (146) | 420 (667) | 3.2 | 0.20 | 0.59 |
| Annealed La_{0.4}Yb_{0.53}Fe₄Sb₁₂ | 105 (172) | 364 (583) | 3.2 | 0.28 | 0.95 |
| La_{0.85}Fe_{2.8}Co_{1.2}Sb₁₂ | 100 (160) | 435 (852) | 3.0 | 0.23 | 0.60 |
| La_{0.4}Yb₀.₅₃Fe_{2.8}Co_{1.2}Sb₁₂ | 116 (184) | 426 (863) | 2.9 | 0.32 | 0.81 |
| Annealed La_{0.4}Yb_{0.53}Fe_{2.8}Co_{1.2}Sb₁₂ | 160 (239) | 696 (886) | 3.1 | 0.40 | 1.24 |

Thermal conductivity (k) of all the compounds were computed after subtracting the electronic contribution. Electronic contribution was estimated from the Wiedeman-Franz law relationship kₑ = L₀σT (Lo is the Lorentz number = 2.44 x 10⁻⁸ W Ω K⁻²) from the measured p values. The temperature dependence of lattice thermal conductivity was estimated between 50 K < T < 100 K. Above RT, the k₁ was computed by extrapolating the temperature dependence to 600 K. The k₁ value at 300 K is considerably lower than that of CoSb₃ which could probably due to the ratting motion of the randomly distributed ions in 'A' site.

Thermal conductivity decreases with Yb doping and upon annealing. Lower thermal conductivity of 2.6 W m⁻¹K⁻¹ is obtained for the composition Ce_{0.85}Fe_{2.8}Co_{1.2}Sb₁₂ and Ce_{0.40}Yb_{0.53}Fe_{2.8}Co_{1.2}Sb₁₂. The relatively low thermal conductivity can be attributed to the high concentration of grain and particle boundaries. A similar trend is observed in the series La_{0.9}Yb_{0.1}Fe₄Sb₁₂ with the lowest k of 2.9 obtained for Ce_{0.40}Yb_{0.53}Fe_{2.8}Co_{1.2}Sb₁₂.

Maximum thermal conductivity is measured for the compositions Ce_{0.85}Fe₄Sb₁₂ and La_{0.40}Fe₄Sb₁₂ in (Ce, Yb) Fe₄Sb₁₂ and (La,Yb)Fe₄Sb₁₂ series respectively. Whilst not wishing to be bound to theory, mixing of these ions might lead to valence fluctuations and decreases thermal conductivity. Yb is a small and heavy filler atom. The thermal conductivity of heavier, smaller filling guest atoms appears to lead to a significant reduction in lattice thermal conductivity compared to bigger, lighter atoms.

The reduction in k by doping with Ce and Yb compared to parent compounds appears to confirm the effective filling of the dodecahedral voids in the lattice. It may be speculated that perhaps the phonon scattering due to grain boundary scattering is dominant at low temperatures where as Umklapp scattering dominates at high temperature regime. In addition, resonant and point defect scatterings could determine the behaviour at intermediate temperatures. In our cases, upon doping and annealing, above RT the thermoelectric figure of merit is dominated by point defect and resonant scattering in reducing the contribution of lattice thermal conductivity.

Substitution of Co at Fe site slightly increases the figure of merit to 1.2, mainly due to the increase in Seebeck coefficient. Similar behaviour is observed in La-Yb-Fe-Sb series, with ZT of 0.28 and 0.95 for annealed La_{0.4}Yb_{0.53}Fe₄Sb₁₂ at 300 K and 600 K respectively.

Substitution of Co at Fe site increases the ZT value, similar to (Ce,Yb) series from 0.40 at 300 K to 1.24 at 600 K. It is surprising that the influence of annealing on ZT is significant. The increase in ZT is a consequence of the balance effect of a increase in S and decrease in p. Both these samples have relative high power factor above room temperature. Values higher than 1.4 can be achieved using the technique described here, or slight variations on the technique as would be understood by experts in the area or by further investigations into these filled skutterudites.

The role of the filler atoms and annealing treatment has been investigated in the thermoelectric power of (Ce,Yb)Fe₄Sb₁₂ and (La, Yb) Fe₄Sb₁₂ filled skutterudites. Dimensionless figure of merit increases dramatically upon annealing in Sb atmosphere. Annealing in an Sb-rich atmosphere increases the thermoelectric power and reduces the thermal conductivity. This provides a path for enhancing the dimensionless figure of merit in these materials by simultaneous void filling and optimized annealing. The results of these materials show promising features for future microelectronic applications.

## Claims

1. A method for producing an intermetallic compound, the method comprising:
(1) providing components A, B and X, wherein A, B and X are:
A is selected from at least two of La, Ce, Pr, Nd, Pm, Sm, Eu, Yb, Ca, Sr, Ba and Tl, and mixtures of three or more thereof;
B is selected from one or more transition metal atoms; and
X is selected from one or more Group IIIA-VIIA atoms;
and forming by solid state reaction of components A, B and X an intermetallic compound having a filled skutterudite structure and formula of
AₐB_{b}X_{c}
wherein A, B and X are as defined above and
a is the sum of all A atoms wherein 0 < a ≤ 1 b is the sum of all B atoms wherein b is in the range of from 3.8 to 4; and
c is the sum of all X atoms wherein 8 ≤ c ≤ 12;
(2) melting the intermetallic compound having a filled skutterudite structure produced in step (1) in the presence of additional X; and
(3) annealing the intermetallic compound of step (2) in the presence of additional X at a temperature equal to, or greater than the phase formation temperature of the intermetallic compound, to form an intermetallic compound exhibiting a ZT₆₀₀ₖ value of ≥ 0.9 and having the formula:
A'_{a'} B'_{b'} X'_{c'}
wherein,
A' is selected from at least two of La, Ce, Pr, Nd, Pm, Sm, Eu, Yb, Ca, Sr, Ba, Tl, and mixtures of three or more thereof;
B' is selected from one or more transition metal atoms;
X' is selected from one or more Group IIIA-VIIA atoms;
a' is the sum of all A atoms wherein 0 < a' ≤ 1
b' is the sum of all B atoms wherein b' is in the range of from 3.8 to 4; and
c' is the sum of all X atoms wherein c' is in the range of from 11 to 12.

2. The method according to claim 1 wherein A, B and X are provided in stoichiometric amounts.

3. The method according to claims 1 or 2 wherein the solid state reaction of A, B and X to form the intermetallic compound having a filled skutterudite structure and a formula of AₐB_{b}X_{c} is carried out by heating at a temperature range of from 500°C to 900°C for from 1 to 7 days.

4. The method according to any one of claims 1 to 3 wherein the intermetallic compound is melted using an arc and/or induction melter.

5. The method according to any one of claims 1 to 4, further comprising a step of pelletising the intermetallic compound provided in step (1) before the melting step (2).

6. The method according to any one of claims 1 to 5, wherein the annealing step (3) is performed for a duration of from 12 to 72 hours.

7. The method according to claim 6, wherein the annealing step (3) is performed for a duration of from 24 to 72 hours.

8. The method according to any one of the preceding claims, wherein A is selected from the rare earth elements and mixtures of two or more thereof.

9. The method according to any one of the preceding claims wherein A is selected from one or more of La, Ce and Yb.

10. The method according to any one of the preceding claims wherein B is selected Fe, Co, Rh, Ru, Os and Ir.

11. The method according to any one of the preceding claims wherein X is selected from C, Si, Ge, Sn, Pb, N, P, As, Sb, Bi, S, Se and Te.

12. The method according to any one of the preceding claims wherein a is in the range of from 0.5 to 1.

13. The method according to any one of the preceding claims wherein a is in the range of from 0.8 to 0.87.

14. The method according to any one of the preceding claims wherein b is 4.

15. The method according to any one of the preceding claims wherein c is 12.

## Patentansprüche

1. Verfahren zur Herstellung einer intermetallischen Verbindung, wobei das Verfahren umfasst:
(1) Bereitstellen von Komponenten A, B und X, wobei A, B und X sind:
A ist ausgewählt aus mindestens zwei von La, Ce, Pr, Nd, Pm, Sm, Eu, Yb, Ca, Sr, Ba und Tl und Mischungen von drei oder mehr davon;
B ist ausgewählt aus einem oder mehreren Übergangsmetallatomen; und
X ist ausgewählt aus einem oder mehreren Gruppe IIIA-VIIA-Atomen;
und Bilden durch Festkörperreaktion der Komponenten A, B und X einer intermetallischen Verbindung mit einer gefüllten Skutterudit-Struktur und der Formel
AₐB_{b}X_{c}
wobei A, B und X wie oben definiert sind und
a die Summe aller A-Atome ist, wobei 0 < a ≤ 1
b die Summe aller B-Atome ist, wobei b im Bereich von 3,8 bis 4 ist; und
c die Summe aller X-Atome ist, wobei 8 ≤ c ≤ 12;
(2) Schmelzen der in Schritt (1) hergestellten intermetallischen Verbindung mit einer gefüllten Skutterudit-Struktur, in Gegenwart eines zusätzlichen X; und
(3) Glühen der intermetallischen Verbindung aus Schritt (2) in Gegenwart eines zusätzlichen X bei einer Temperatur gleich zu oder größer als die Phasenbildungstemperatur der intermetallischen Verbindung, um eine intermetallische Verbindung zu bilden, die einen ZT₆₀₀ₖ-Wert von ≥ 0,9 aufweist und die Formel:
A'ₐ,B'_{b'}X'_{c'},
wobei
A' ausgewählt ist aus mindestens zwei von La, Ce, Pr, Nd, Pm, Sm, Eu, Yb, Ca, Sr, Ba und Tl und Mischungen von drei oder mehr davon;
B' ausgewählt ist aus einem oder mehreren Übergangsmetallatomen; und
X' ausgewählt ist aus einem oder mehreren Gruppe IIIA-VIIA-Atomen;
a' die Summe aller A-Atome ist, wobei 0 < a' ≤ 1
b' die Summe aller B-Atome ist, wobei b' im Bereich von 3,8 bis 4 ist; und
c' die Summe aller X-Atome ist, wobei c' im Bereich von 11 bis 12 ist.

2. Verfahren nach Anspruch 1, wobei A, B und X in stöchiometrischen Mengen bereitgestellt werden.

3. Verfahren nach Ansprüchen 1 oder 2, wobei die Festkörperreaktion von A, B und X, um die intermetallische Verbindung mit einer gefüllten Skutterudit-Struktur und einer Formel von AₐB_{b}X_{c} zu bilden, durch Erhitzen bei einem Temperaturbereich von 500°C bis 900°C für von 1 bis 7 Tage durchgeführt wird.

4. Verfahren nach einem der Ansprüche 1 bis 3, wobei die intermetallische Verbindung unter Verwendung eines Lichtbogenofens oder Induktionsofens geschmolzen wird.

5. Verfahren nach einem der Ansprüche 1 bis 4, weiter umfassend einen Schritt Pelletieren der in Schritt (1) bereitgestellten intermetallischen Verbindung vor dem Schmelzschritt (2).

6. Verfahren nach einem der Ansprüche 1 bis 5, wobei der Glühschritt (3) für eine Dauer von 12 bis 72 Stunden durchgeführt wird.

7. Verfahren nach Anspruch 6, wobei der Glühschritt (3) für eine Dauer von 24 bis 72 Stunden durchgeführt wird.

8. Verfahren nach einem der vorhergehenden Ansprüche, wobei A ausgewählt ist aus den Seltenerdmetallen und Mischungen von zwei oder mehr davon.

9. Verfahren nach einem der vorhergehenden Ansprüche, wobei A ausgewählt ist aus einem oder mehreren von La, Ce und Yb.

10. Verfahren nach einem der vorhergehenden Ansprüche, wobei B ausgewählt ist aus Fe, Co, Rh, Ru, Os und Ir.

11. Verfahren nach einem der vorhergehenden Ansprüche, wobei X ausgewählt ist aus C, Si, Ge, Sn, Pb, N, P, As, Sb, Bi, S, Se und Te.

12. Verfahren nach einem der vorhergehenden Ansprüche, wobei a im Bereich von 0,5 bis 1 ist.

13. Verfahren nach einem der vorhergehenden Ansprüche, wobei a im Bereich von 0,8 bis 0,87 ist.

14. Verfahren nach einem der vorhergehenden Ansprüche, wobei b 4 ist.

15. Verfahren nach einem der vorhergehenden Ansprüche, wobei c 12 ist.

## Revendications

1. Procédé de production d'un composé intermétallique, le procédé comprenant le fait :
(1) de fournir des composants A, B et X, où A, B et X sont :
A est choisi parmi au moins deux éléments parmi le La, Ce, Pr, Nd, Pm, Sm, Eu, Yb, Ca, Sr, Ba et le Tl, et des mélanges de trois ou plus de ceux-ci ;
B est choisi parmi un ou plusieurs atome(s) de métal de transition ; et
X est choisi parmi un ou plusieurs atome(s) du groupe IIIA-VIIA ;
et de former, par une réaction à l'état solide des composants A, B et X, un composé intermétallique présentant une structure skutterudite remplie et dont la formule et
AₐB_{b}X_{c}
où A, B et X sont tels que définis ci-dessus et
a est la somme de tous les atomes A, où 0 < a ≤ 1
b est la somme de tous les atomes B, où b est dans la plage allant de 3,8 à 4 ; et
c est la somme de tous les atomes X, où 8 ≤ c ≤ 12 ;
(2) de fondre le composé intermétallique présentant une structure skutterudite remplie produite à l'étape (1) en présence de X supplémentaire ; et
(3 ) de recuire le composé intermétallique de l'étape (2) en présence de X supplémentaire à une température supérieure ou égale à la température de formation de phase du composé intermétallique, pour former un composé intermétallique présentant une valeur de ZT₆₀₀ₖ ≥ 0,9 et ayant la formule :
A'ₐ, B'_{b'} X'_{c'}
où,
A' est choisi parmi au moins deux éléments parmi le La, Ce, Pr, Nd, Pm, Sm, Eu, Yb, Ca, Sr, Ba, Tl, et des mélanges de trois ou plus de ceux-ci ;
B' est choisi parmi un ou plusieurs atome(s) de métal de transition ;
X' est choisi parmi un ou plusieurs atome(s) du groupe IIIA-VIIA ;
a' est la somme de tous les atomes A, où 0 < a' ≤ 1
b' est la somme de tous les atomes B, où b' est dans la plage allant de 3,8 à 4 ; et
c' est la somme de tous les atomes X, où c' est dans la plage allant de 11 à 12.

2. Procédé selon la revendication 1, dans lequel A, B et X sont fournis en quantités stoechiométriques.

3. Procédé selon la revendication 1 ou 2, dans lequel la réaction à l'état solide de A, B et X pour former le composé intermétallique présentant une structure skutterudite remplie et une formule de AₐB_{b}X_{c} est réalisée par chauffage à une plage de température comprise entre 500°C et 900°C pendant 1 à 7 jours.

4. Procédé selon l'une quelconque des revendications 1 à 3, dans lequel le composé intermétallique est fondu en utilisant un arc et/ou un four de fusion par induction.

5. Procédé selon l'une quelconque des revendications 1 à 4, comprenant en outre une étape de granulation du composé intermétallique prévu dans l'étape (1) avant l'étape de fusion (2).

6. Procédé selon l'une quelconque des revendications 1 à 5, dans lequel l'étape de recuit (3) est réalisée pendant une durée de 12 à 72 heures.

7. Procédé selon la revendication 6, dans lequel l'étape de recuit (3) est réalisée pendant une durée de 24 à 72 heures.

8. Procédé selon l'une quelconque des revendications précédentes, dans lequel A est choisi parmi les éléments des terres rares et des mélanges de deux ou plus de ceux-ci.

9. Procédé selon l'une quelconque des revendications précédentes, dans lequel A est choisi parmi un ou plusieurs élément(s) de La, Ce et Yb.

10. Procédé selon l'une quelconque des revendications précédentes, dans lequel B est choisi parmi le Fe, Co, Rh, Ru, Os et l'Ir.

11. Procédé selon l'une quelconque des revendications précédentes, dans lequel X est choisi parmi le C, Si, Ge, Sn, Pb, N, P, As, Sb, Bi, S, Se et le Te.

12. Procédé selon l'une quelconque des revendications précédentes, dans lequel a est dans la plage allant de 0,5 à 1.

13. Procédé selon l'une quelconque des revendications précédentes, dans lequel a est dans la plage allant de 0,8 à 0, 87.

14. Procédé selon l'une quelconque des revendications précédentes, dans lequel b est égal à 4.

15. Procédé selon l'une quelconque des revendications précédentes, dans lequel c est égal à 12.
